# EUROPEAN PATENT APPLICATION

(11) **EP 4 239 099 A1**
(43) Date of publication of application: **06.09.2023**
(21) Application number: 21885036.0
(22) Date of filing: 22.10.2021
(51) Int. Cl.: C23C 14/54

(54) **METHOD FOR CORRECTING THICKNESS DISTRIBUTION AND UNIFORMITY DEGREE OF FILM LAYER OF RESONATOR**

(30) Priority: 28.10.2020 CN 202011172175
(71) Applicant: Harbin Institute Of Technology, Harbin, Heilongjiang 150080 (CN)
(72) Inventor: XU, Liangge, Harbin, Heilongjiang 150080 (CN); YANG, Lei, Harbin, Heilongjiang 150080 (CN); YANG, Jinye, Harbin, Heilongjiang 150080 (CN); ZHU, Jiaqi, Harbin, Heilongjiang 150080 (CN)
(74) Representative: Meyer-Dulheuer MD Legal Patentanwälte PartG mbB
(86) International application number: PCT/CN2021/125557
(87) International publication number: WO 2022/089309

(57) **Abstract**

The present invention relates to a method for correcting thickness distribution and uniformity of a harmonic oscillator film and a method for manufacturing a hemispherical harmonic oscillator. The method for correcting thickness distribution and uniformity of a harmonic oscillator film comprises the following steps: acquiring three-dimensional data of a coating device and a coated workpiece; establishing a three-dimensional model of the coated workpiece and an effective coating area according to the obtained three-dimensional data, and dividing a coating surface of the coated workpiece into grids along the radial distribution; obtaining, by finite element simulation, film thickness distribution and uniformity data of the coated workpiece, that is, a hemispherical harmonic oscillator, on the coating surface corresponding to different process parameters. In the process of coating, the coating thickness parameters are collected, the thickness distribution and uniformity of the film are dynamically analyzed, and the coating process parameters are corrected according to the obtained film thickness and uniformity results, so that the uniformity of the film thickness distribution is continuously improved. By adopting the present method, a uniform coating required by the hemispherical harmonic oscillator can be quickly realized, and the quality of products in the actual coating process can be improved.

## Description

### TECHNICAL FIELD

The present invention relates to the technical field of hemispherical harmonic oscillator gyroscopes, in particular to a method for correcting the thickness distribution and uniformity of a harmonic oscillator film and a method for manufacturing a hemispherical harmonic oscillator.

### BACKGROUND

A hemispherical resonator gyro (HRG) is a kind of high-precision gyro with inertial navigation level performance, which has been widely used in aerospace, ships, weapons and other fields in recent years, and is an extremely important part of inertial navigation and guidance, vehicle attitude stability control, inertial measurement and other units.

Metallization coating on the surface of the harmonic oscillator is an important process link in the manufacture of hemispherical harmonic oscillator. The harmonic oscillator is made of quartz glass with a high Q value through ultra-precision machining. Since the hemispherical resonant gyro works by vibrating the harmonic oscillator and collecting vibration signals, the insulating surface of the harmonic oscillator needs to be metallized to make it conductive. The thickness and uniformity of the metallized film on the surface of the harmonic oscillator have an important influence on the Q value and frequency difference of the harmonic oscillator. If the metallized film is not uniform, the Q value of the harmonic oscillator will decrease and the frequency difference will increase, which will directly affect the performance of the harmonic oscillator. Due to the special shape of the coated workpiece, that is, the hemispherical harmonic oscillator, and the high requirement for the uniformity of the metallized film, the traditional coating method has long test period, complex process, poor systematicness and high cost, and it is difficult to achieve rapid and efficient coating of the

### SUMMARY

The purpose of the present invention is to provide a hemispherical harmonic oscillator coating method suitable for industrial production in order to improve the coating efficiency of a hemispherical harmonic oscillator and the reliability of uniformity control in the coating process.

In order to achieve the above objectives, the present invention provides a method for correcting thickness distribution and uniformity of a harmonic oscillator film, which includes the following steps:
S1, acquiring three-dimensional data of a coating device and a coated workpiece, and determining process parameters affecting a coating result; wherein the coated workpiece is a hemispherical harmonic oscillator, and the process parameters at least comprise a relative position between a coating source of the coating device and the coated workpiece;
S2, in finite element simulation software, establishing a three-dimensional model of the coated workpiece and an effective coating area according to the obtained three-dimensional data; in the three-dimensional model, dividing a coating surface of the coated workpiece to be coated into grids along radial distribution, and adding constraint conditions according to the measured three-dimensional data and a range of the process parameters;
S3, solving, by finite element simulation, corresponding film thickness distribution and uniformity data on the coated workpiece obtained after coating with different process parameters;
S4, composing different groups of process parameters and the corresponding film thickness distribution and uniformity data into sample data groups, and storing the sample data groups in a database;
S5, searching in the database according to film thickness and uniformity indices required to be set for actual coating, obtaining sample data groups which match or partially match the film thickness and uniformity indices, and screening; sending a feedforward control signal to the coating device according to the process parameters in the screened sample data groups, setting the coating device, and starting coating after the setting is completed;
S6, in a film coating process, monitoring obtained film thickness and uniformity results by a sensor in real time, and comparing the actually obtained film thickness and uniformity results with the set film thickness and uniformity indices after finishing the film coating in a preset time period; if there is a deviation, searching the database again for sample data groups that match or partially match the deviation, and screening; sending a feedback control signal to the coating device according to the process parameters in the screened sample data groups, adjusting the coating device and continuing coating after the adjustment is completed; if there is no deviation, completing the coating;
S7, repeating the above step S6 until the coating is completed.

Preferably, the three-dimensional data obtained in step S1 at least comprise a geometric size of the coating source, a coating range, a position of the coating source, a position of the coated workpiece and a geometric size of the coated workpiece.

Preferably, in step S 1, the process parameters further comprise a rotation angle and a swing angle of the coated workpiece.

Preferably, in step S3, when the film thickness distribution and uniformity data are solved by finite element simulation, the coating process is set so that isotropic particles with uniform directions are deposited on the coating surface at a set speed along a coating direction; a boundary of a simulation calculation is determined by using the constraint conditions, and the calculation is carried out according to the divided grids, so that the film thickness distribution and uniformity data are obtained from particle number distribution.

Preferably, in step S5, when the database is searched to obtain sample data groups that match or partially match the film thickness and uniformity indices and the sample data groups are screened,
if there is a sample data group matched with the film thickness and uniformity indices, the matched sample data group is screened out; otherwise, sample data groups with film thickness distribution data not exceeding the film thickness index and film uniformity data closest to the film uniformity index are screened out.

Preferably, in step S6, when the database is searched again to obtain sample data groups that match or partially match the deviation and the sample data groups are screened,
if there is a sample data group matching the deviation, the matched sample data group is screened out; otherwise, sample data groups with film thickness distribution data not exceeding the thickness distribution in the deviation and film uniformity data closest to the film uniformity in the deviation are screened out.

Preferably, in step S6, after finishing the coating for a preset time period, the method further includes:
comparing the actual film thickness and uniformity results with the film thickness distribution and uniformity data in a sample data group based on which the coating device was set; if there is an error and the error exceeds a preset error value, returning to step S 1; if there is an error but the error does not exceed the preset error value, correcting the sample data group based on which the coating device is set according to the actually obtained film thickness and uniformity results, and updating the database.

Preferably, the step S7 further includes arranging all the sample data groups according to an execution order, and constituting a new sample data group by taking the arranged sample data groups as a combination and storing new sample data group in the database.

Preferably, in step S6, a PID controller is adopted to receive the film thickness and uniformity results obtained by real-time monitoring of the sensor, and the PID controller is also used to compare the actually obtained film thickness and uniformity results with the set film thickness and uniformity indices, and search the database and screen; and the PID controller calls the process parameters in the screened sample data groups to send the feedback control signal to the coating device.

The present invention further provides a method for manufacturing a hemispherical harmonic oscillator, wherein the hemispherical harmonic oscillator to be coated is coated by any of the above method for correcting thickness distribution and uniformity of a harmonic oscillator film.

The technical solution provided by the present invention has the following advantages: the present invention provides a method for correcting thickness distribution and uniformity of the film of a harmonic oscillator and a method for manufacturing the hemispherical harmonic oscillator. Based on the finite element simulation technology, the present invention calculates the thickness distribution and uniformity of the film on the surface of the coated workpiece (i.e., the hemispherical harmonic oscillator) when coating with different process parameters, measures the actual film thickness and uniformity during the coating process, carries out dynamic analysis, and dynamically corrects the process parameters for coating according to the finite element simulation results, so that the thickness and uniformity of the film are continuously improved, and finally the technological requirements for manufacturing the hemispherical resonator are met. According to the present invention, the thickness distribution and uniformity data of the film are obtained by finite element simulation, so that the realizable degree and difficulty degree of coating can be evaluated in advance, the coating efficiency is greatly improved, and the test cost is reduced; through simulation calculation, more intuitive results can be obtained systematically, which provides technical support for studying the influence of process parameters on film uniformity during coating. By using feedback control, the coating parameters are corrected in the coating process to improve the coating uniformity, accuracy and reliability, which is suitable for industrial production.

### BRIEF DESCRIPTION OF DRAWINGS

FIG. 1 is a schematic diagram of a method for correcting thickness distribution and uniformity of a harmonic oscillator film in an embodiment of the present invention;
FIG. 2 is a flowchart of a method for correcting thickness distribution and uniformity of a harmonic oscillator film in an embodiment of the present invention;
FIG. 3 is a schematic diagram of the relationship between non-uniformity and coating time during actual coating of a method for correcting thickness distribution and uniformity of a harmonic oscillator film in the embodiment of the present invention; and
FIG. 4 is a schematic diagram of the relationship between non-uniformity and coating time during actual coating according to another method for correcting thickness distribution and uniformity of a harmonic oscillator film in the embodiment of the present invention.

### DESCRIPTION OF EMBODIMENTS

In order to make the purpose, technical solution and advantages of the embodiment of the present invention more clear, the technical solution in the embodiment of the present invention will be described clearly and completely with the attached drawings. Obviously, the described embodiment is a part of the embodiment of the present invention, but not the whole embodiment. Based on the embodiments in the present invention, all other embodiments obtained by those skilled in the art without creative work belong to the scope of protection of the present invention.

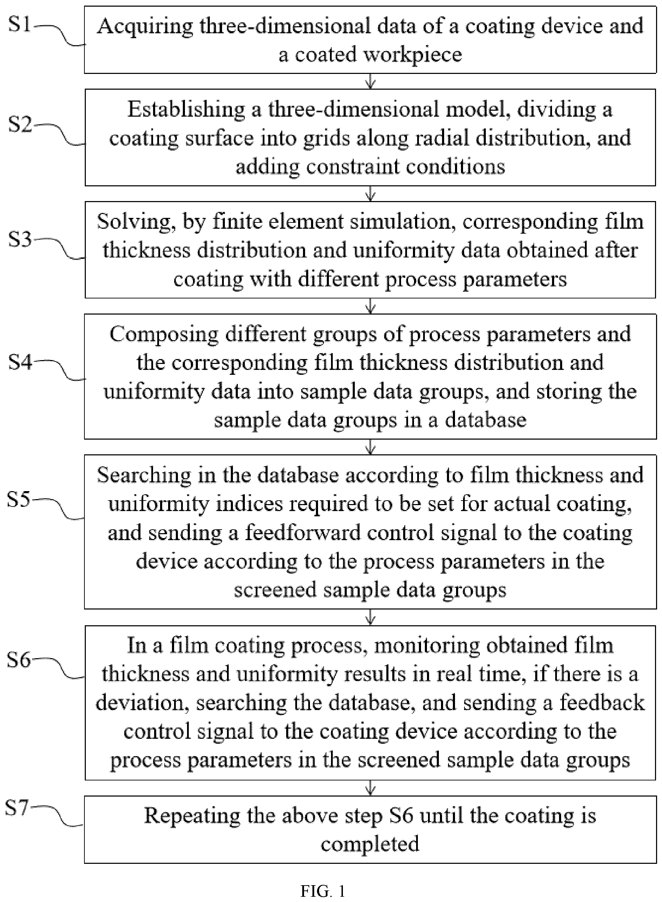

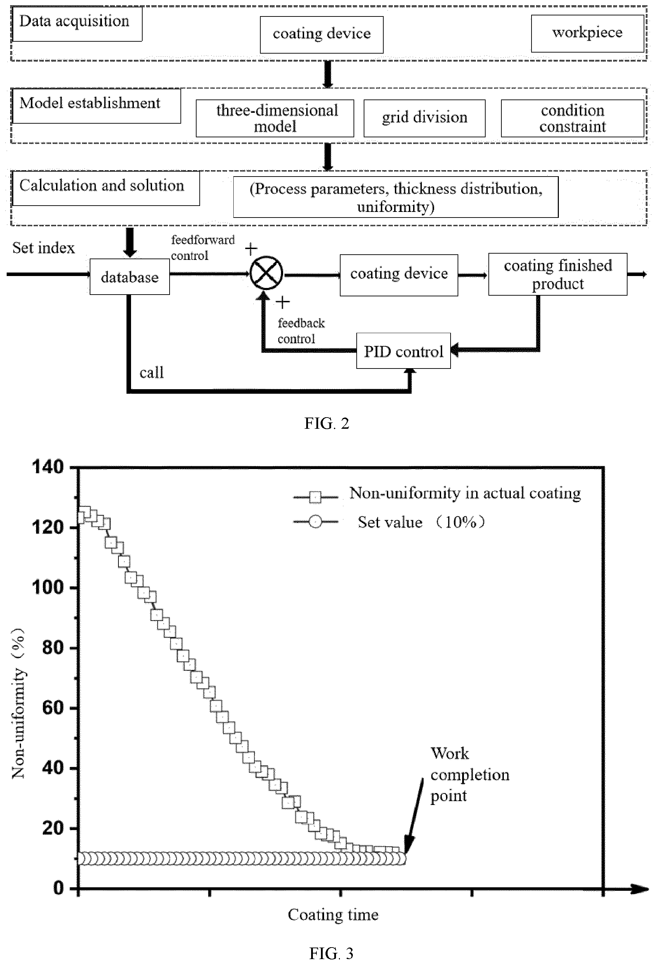

As shown in FIG. 1 and FIG. 2, a method for correcting thickness distribution and uniformity of a harmonic oscillator film provided by an embodiment of the present invention includes the following steps:
S 1, three-dimensional data of a coating device and a coated workpiece are acquired, and the process parameters affecting a coating result are determined; wherein the coated workpiece is a hemispherical harmonic oscillator (to be coated), and the process parameters at least comprise a relative position between a coating source of the coating device and the coated workpiece;
Due to the special shape of the hemispherical harmonic oscillator and the high requirements for the thickness and uniformity of the film, it is necessary to measure the coating device and coated workpiece that actually perform coating. If the coating device and coated workpiece are replaced, it is necessary to measure the replaced coating device and coated workpiece again.

Preferably, the three-dimensional data obtained in step S1 at least comprise a geometric size of the coating source, a coating range, a position of the coating source, a position of the coated workpiece and a geometric size of the coated workpiece.

Further, in step S 1, the process parameters that affect the coating results also include the rotation angle and swing angle of the coated workpiece.

S2, in the finite element simulation software, according to the three-dimensional data obtained in step S2, a three-dimensional model of the coated workpiece and the effective coating area is established to complete three-dimensional reconstruction; because the gyro is a revolving body, in the three-dimensional model, the coated surface of the coated workpiece is divided into grids along the radial distribution, and constraint conditions are added according to the measured three-dimensional data and the range of process parameters, that is, boundary conditions are added for the subsequent finite element simulation. Preferably, the constraint conditions at least include the distance range between the coating source and the coated workpiece. Further, the constraint conditions also include the rotation angle range and the swing angle range of the coated workpiece.

In the established three-dimensional model, the model of the coated workpiece should strictly correspond to its actual geometric shape and size, and the coating device can be abstracted as an effective coating area (which can coat the coated workpiece entering this area). The center of the effective coating area corresponds to the coating source of the coating device, and the relative position between the coating source of the coating device and the coated workpiece, that is, the relative position between the center of the effective coating area and the coated workpiece. Further, in the established three-dimensional model, the effective coating area can be constructed according to the geometric size, coating range and coating source position of the coating device obtained in step S1.

S3, in the finite element simulation software, corresponding film thickness distribution and uniformity data on the coated workpiece obtained after coating with different process parameters are solved by finite element simulation.

Preferably, in step S3, when the film thickness distribution and uniformity data are solved by finite element simulation, the coating process is set so that isotropic particles (in the effective coating area) are deposited on the coating surface of the coated workpiece (in the three-dimensional model) at a set speed; the boundary of simulation calculation is determined by using constraint conditions, and the film thickness distribution and uniformity data are obtained from particle number distribution according to the grids divided by the coating surface. That is, in finite element simulation, the number of particles distributed on the coating surface is counted, and the counted number of particles represents the thickness distribution of the film, and a large number of particles represents a large thickness.

This step is intended to traverse all possible combinations of process parameters, and determine the corresponding coating results through finite element simulation. In actual simulation, discrete values can be obtained according to the ranges of various process parameters. For example, for the rotation angle of the coated workpiece, the rotation angle ranges from 0 to 180°, and if it is divided once every 1°, 181 different discrete values can be obtained for this process parameter. Through the combination of different process parameters, a variety of different coating results may be obtained. In addition, the step size of simulation calculation will also affect the calculation amount and speed. The discrete values of specific process parameters and the step size of simulation calculation can be set according to actual demands, and are not further limited here.

S4, different groups of process parameters and corresponding film thickness distribution and uniformity data are composed into a sample data group, and the sample data group is stored in a database.

This step is intended to establish a database, which contains a plurality of sample data groups, and each sample data group includes the setting mode of coating (process parameters) and the results after coating (corresponding film thickness distribution and uniformity data).

S5, film thickness and uniformity indices are set according to actual coating requirements; according to the set film thickness and uniformity indices, the database obtained in step S4 is searched to obtain sample data groups (film thickness distribution and uniformity data) that matches or partially matches the film thickness and uniformity indices, and the sample data groups are screened; according to the process parameters in the screened sample data groups, a feed-forward control signal is sent to the coating device, and the coating device is set, and coating is started after the setting is completed.

This step no longer depends on the finite element simulation software, but sets the required film thickness and uniformity indices in the actual coating process, sends a feedforward control signal to the coating device according to the existing coating results (and their corresponding process parameters) in the database, sets the coating device with reference to the process parameters in the sample data group, and the coating device starts coating.

S6, in the film coating process, the film thickness and uniformity obtained through real-time monitoring by the sensor are compared with the set film thickness and uniformity indices after the film coating is completed in a preset time period; if there is a deviation between the actually obtained film thickness and uniformity result and the set film thickness and uniformity indices, the sample data groups in the database obtained in step S4 are searched again for the sample data groups (film thickness and uniformity results) match or partially match (thickness distribution and uniformity in) the deviation, and the sample data groups are screened, and a feedback control signal is sent to the coating device according to the process parameters in the screened sample data group to adjust the coating device; coating is continued after the adjustment is completed; if there is no deviation between the actual film thickness and uniformity result and the set film thickness and uniformity indices, the coating is completed and the final coating product is obtained.

S7, the above step S6 is repeated until the coating is completed.

Through repeated feedback control, the film thickness and uniformity can be continuously improved.

The uniformity of film thickness distribution can be expressed by non-uniformity. As shown in FIG. 3, in a specific embodiment, the setting value of the corresponding uniformity in the coating index is that the unevenness does not exceed 10%. By repeatedly executing step S6 in the coating process, the film thickness distribution and uniformity are continuously corrected, and the uniformity in actual coating is gradually improved, that is, the unevenness is gradually decreased, and it is constantly close to the set film index. Finally, when the actually obtained film thickness and uniformity results have no deviation or are better than the set value as compared with the set film thickness and uniformity indices, the coating is completed.

According to the method for correcting thickness distribution and uniformity of a harmonic oscillator film, feedback signals of the thickness and uniformity are obtained in the film coating process, and the real-time film coating situation is compared with the set indices; when the real-time film coating situation does not meet the set indices, a database is called to send a feedback control signal to the film coating device to correct the film coating parameters. By dynamically analyzing the film thickness distribution and uniformity, the obtained film thickness distribution and uniformity data (and corresponding process parameters) are adjusted, so that the film thickness distribution uniformity is continuously improved, the product quality in the actual coating process is improved, the test cost is reduced, and the efficiency is improved.

Preferably, in step S5, the database is searched to obtain a sample data group that matches or partially matches the film thickness and uniformity indices, and when screening, if there is a sample data group that matches the film thickness and uniformity indices, that is, the film thickness distribution and uniformity data (coating results) in the sample data group completely meet the set film thickness and uniformity indices (coating requirements), then the matched sample data group is screened. If there is no completely matched sample data group, that is, the coating results of the existing groups of process parameters in the database can not fully meet the coating requirements, such as insufficient film thickness, etc., the sample data group with film thickness distribution data not exceeding the film thickness index and film uniformity data closest to the film uniformity index is selected. When there is no data that completely meets the requirements, the data with the uniformity closest to the index requirements is selected, so that the final actual coating result is closest to the set coating requirements.

Further, in step S6, the database is searched again to obtain a sample data group with film thickness distribution data matching or not exceeding the thickness distribution in the deviation, and when screening, if there is a sample data group matching the deviation, that is, the coating result meets the deviation, the matched sample data group is screened out; otherwise, the sample data group with film thickness distribution data not exceeding the thickness distribution in the deviation and film uniformity data closest to the film uniformity in deviation is screened out. In particular, the film uniformity data can also be better than the film uniformity in the deviation, that is, the final actual coating result is slightly better than the set coating requirements.

Considering that the actual coating may deviate from the finite element simulation result, it is preferable that in step S6, after the coating is completed for a preset time period, and before comparing the actually obtained film thickness and uniformity result with the set film thickness and uniformity indices, it further includes:

comparing the actual film thickness and uniformity results with the film thickness distribution and uniformity data in a sample data group based on which the coating device was set; if there is an error and the error exceeds a preset error value, returning to step S 1; if there is an error but the error does not exceed the preset error value, correcting the sample data group based on which the coating device is set according to the actually obtained film thickness and uniformity results, and updating the database.

According to the actual coating results, updating the coating results in the reference database can improve the accuracy and reliability of the database. Moreover, when there is obvious difference between the actual coating results and the simulated coating results (that is, there is an error between the actual and simulated coating film thickness distribution and uniformity exceeding the preset error value under the same coating conditions), it can be considered that the simulation results in the database have no guiding role for coating production and should be modeled and simulated again.

Preferably, in order to improve the production efficiency, step S7 further includes arranging all the sample data groups according to the execution order (in a complete coating process), that is, arranging all the sample data groups participating in setting or adjusting the coating device in the order of participation, and constituting a new sample data group by taking the sample data groups arranged in the execution order as a combination and storing the new sample data group in the database.

Further, when a new sample data group is formed by taking each sample data group arranged in the execution order as a combination, the process parameters of each sample data group are arranged in the execution order to form a new combined process parameter (when participating in setting or adjusting the coating device, the coating device needs to execute each group of process parameters in sequence according to the arrangement order of each group of process parameters in the combined process parameter), and the film thickness distribution and uniformity data corresponding to the combined process parameter participate in setting or adjusting each sample data group in the combination.

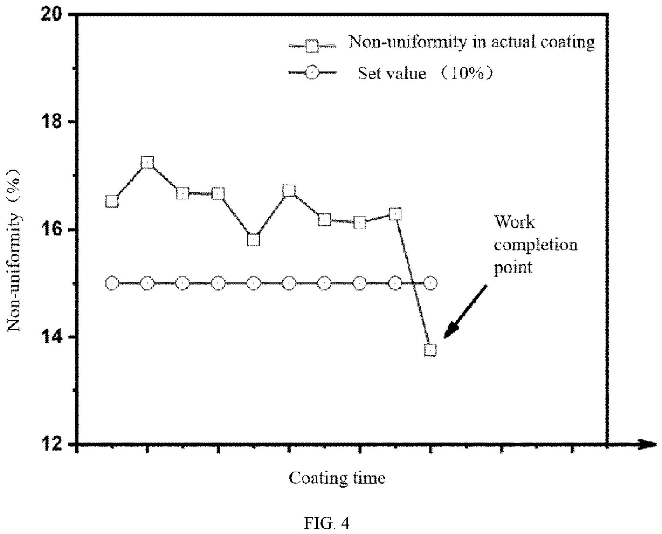

As shown in FIG. 4, in a specific embodiment, the set value is that the non-uniformity does not exceed 15%. After the first coating, the corrected solution obtained by adjusting the feedback control process for many times (that is, the combined solution composed of multiple groups of sample data groups in the execution order) is also saved in the database, which can enrich the database content. When the same coated workpiece and the set index are encountered again, the corrected solution saved in the data can be directly and repeatedly called for coating, and it is not necessary to repeatedly execute step S6, thus improving the production efficiency.

Preferably, in step S6, a PID controller is used to receive the results of film thickness and uniformity obtained by real-time monitoring of the sensor, and the PID controller is also used to compare the actual results of film thickness and uniformity with the set film thickness and uniformity indices, and to search the database and screen, and the PID controller calls the process parameters in the screened sample data group to send a feedback control signal to the coating device. The PID controller is a controller that can best reflect the feedback idea. As shown in FIG. 2, using A PID controller to complete the feedback control can control the film thickness uniformity in the coating process as much as possible, with stable structure, strong robustness and applicability, and is suitable for industrial production.

The present invention also provides a method for manufacturing a hemispherical harmonic oscillator, which adopt the method for correcting thickness distribution and uniformity of a harmonic oscillator film as described in any one of the above embodiments to coat the hemispherical harmonic oscillator to be coat, so as to obtain a hemispherical harmonic oscillator with a uniform film and meeting the requirements.

To sum up, the present invention provides a method for correcting thickness distribution and uniformity of a harmonic oscillator film and a method for manufacturing a hemispherical harmonic oscillator. The present invention accurately obtains the thickness distribution and uniformity of a harmonic oscillator film coating surface through finite element simulation; the use of finite element simulation software reduces the test cost and eliminates unnecessary test processes; by forming a database and introducing feedback control, the uniformity control in the coating process is improved, and the production quality and efficiency are improved.

Finally, it should be explained that the above embodiments are only used to illustrate the technical solution of the present invention, but not to limit it; although the present invention has been described in detail with reference to the foregoing embodiments, those skilled in the art should understand that it is still possible to modify the technical solution described in the foregoing embodiments, or to replace some technical features with equivalents; however, these modifications or substitutions do not make the essence of the corresponding technical solutions deviate from the spirit and scope of the technical solutions of various embodiments of the present invention.

## Claims

1. A method for correcting thickness distribution and uniformity of a harmonic oscillator film, comprising the following steps:
S1, acquiring three-dimensional data of a coating device and a coated workpiece, and determining process parameters affecting a coating result; wherein the coated workpiece is a hemispherical harmonic oscillator, and the process parameters at least comprise a relative position between a coating source of the coating device and the coated workpiece;
S2, in finite element simulation software, establishing a three-dimensional model of the coated workpiece and an effective coating area according to the obtained three-dimensional data; in the three-dimensional model, dividing a coating surface of the coated workpiece to be coated into grids along radial distribution, and adding constraint conditions according to the measured three-dimensional data and a range of the process parameters;
S3, solving, by finite element simulation, corresponding film thickness distribution and uniformity data on the coated workpiece obtained after coating with different process parameters;
S4, composing different groups of process parameters and the corresponding film thickness distribution and uniformity data into sample data groups, and storing the sample data groups in a database;
S5, searching in the database according to film thickness and uniformity indices required to be set for actual coating, obtaining sample data groups which match or partially match the film thickness and uniformity indices, and screening; sending a feedforward control signal to the coating device according to the process parameters in the screened sample data groups, setting the coating device, and starting coating after the setting is completed;
S6, in a film coating process, monitoring obtained film thickness and uniformity results by a sensor in real time, and comparing the actually obtained film thickness and uniformity results with the set film thickness and uniformity indices after finishing the film coating in a preset time period; if there exists a deviation, searching the database again for sample data groups that match or partially match the deviation, and screening; sending a feedback control signal to the coating device according to the process parameters in the screened sample data groups, adjusting the coating device and continuing coating after the adjustment is completed; if there is no deviation, completing the coating; and
S7, repeating the above step S6 until the coating is completed.

2. The method for correcting thickness distribution and uniformity of a harmonic oscillator film according to claim 1, wherein,
the three-dimensional data obtained in step S1 at least comprise a geometric size of the coating source, a coating range, a position of the coating source, a position of the coated workpiece and a geometric size of the coated workpiece.

3. The method for correcting thickness distribution and uniformity of a harmonic oscillator film according to claim 1, wherein,
in step S1, the process parameters further comprise a rotation angle and a swing angle of the coated workpiece.

4. The method for correcting thickness distribution and uniformity of a harmonic oscillator film according to claim 1, wherein,
in step S3, when the film thickness distribution and uniformity data are solved by finite element simulation, the coating process is set so that isotropic particles are deposited on the coating surface at a set speed along a coating direction; a boundary of a simulation calculation is determined by using the constraint conditions, and the calculation is carried out according to the divided grids, so that the film thickness distribution and uniformity data are obtained from particle number distribution.

5. The method for correcting thickness distribution and uniformity of a harmonic oscillator film according to claim 1, wherein,
in step S5, when the database is searched to obtain sample data groups that match or partially match the film thickness and uniformity indices and the sample data groups are screened:
if there is a sample data group matched with the film thickness and uniformity indices, the matched sample data group is screened out; otherwise, sample data groups with film thickness distribution data not exceeding the film thickness index and film uniformity data closest to the film uniformity index are screened out.

6. The method for correcting thickness distribution and uniformity of a harmonic oscillator film according to claim 5, wherein,
in step S6, when the database is searched again to obtain sample data groups that match or partially match the deviation and the sample data groups are screened:
if there is a sample data group matching the deviation, the matched sample data group is screened out; otherwise, sample data groups with film thickness distribution data not exceeding the thickness distribution in the deviation and film uniformity data closest to the film uniformity in the deviation are screened out.

7. The method for correcting thickness distribution and uniformity of a harmonic oscillator film according to claim 1, wherein,
in step S6, after finishing the coating for a preset time period, the method further comprises:
comparing the actual film thickness and uniformity results with the film thickness distribution and uniformity data in a sample data group based on which the coating device was set; if there is an error and the error exceeds a preset error value, returning to step S 1; if there is an error but the error does not exceed the preset error value, correcting the sample data group based on which the coating device is set according to the actually obtained film thickness and uniformity results, and updating the database.

8. The method for correcting thickness distribution and uniformity of a harmonic oscillator film according to claim 1, wherein,
the step S7 further comprises arranging all the sample data groups according to an execution order, and constituting a new sample data group by taking the arranged sample data groups as a combination and storing new sample data group in the database.

9. The method for correcting thickness distribution and uniformity of a harmonic oscillator film according to claim 1, wherein,
in step S6, a PID controller is adopted to receive the film thickness and uniformity results obtained by real-time monitoring of the sensor, and the PID controller is also used to compare the actually obtained film thickness and uniformity results with the set film thickness and uniformity indices, and search the database and screen; and the PID controller calls the process parameters in the screened sample data groups to send the feedback control signal to the coating device.

10. A method for manufacturing a hemispherical harmonic oscillator, wherein the hemispherical harmonic oscillator to be coated is coated by the method for correcting thickness distribution and uniformity of a harmonic oscillator film according to any one of claims 1 to 9.
